# EUROPÄISCHE PATENTANMELDUNG

(11) **EP 4 141 595 A1**
(43) Veröffentlichungstag der Anmeldung: **01.03.2023**
(21) Anmeldenummer: 21193259.5
(22) Anmeldetag: 26.08.2021
(51) Int. Cl.: G05B 19/418, G05B 23/02, G05B 19/042, B29C 64/10, B33Y 99/00

(54) **VERFAHREN ZUR ERKENNUNG VON ANOMALIEURSACHEN EINES PHYSISCHEN PRODUKTES**

(71) Anmelder: Siemens Aktiengesellschaft, 80333 München (DE)
(72) Erfinder: Hauser, Tobias, 89347 Bubesheim (DE); Lutz, Benjamin Samuel, 81739 München (DE); Pantano, Matteo, 81737 München (DE); Regulin, Daniel, 81825 München (DE); Reisch, Raven Thomas, 81379 München (DE)

(57) **Zusammenfassung**

Zur Herstellung bzw. Fertigung eines physischen Produkts (2) ggf. mittels eines additiven Fertigungsverfahren (32), durchläuft dieses einen Produktzyklus (3), der ein CAD Designverfahren (4), ein CAM Fertigungsprogramm (5), ein Herstellungsverfahren (6) und eine Qualitätsprüfung (14) umfasst. Es wird eine semantisch verknüpfte digitale Repräsentation (8) des physischen Produkts (2) erstellt, welche z.B. einen Knowledge Graph (24) umfasst. Die digitale Repräsentation (8) umfasst beispielsweise Konstruktionsvorgänge, die durch ein CAD System erfolgen, Fertigungssimulationen, die durch ein CAM Verfahren erfolgen, sowie die physische Fertigung, wobei Prozessdaten, und Prozessüberwachungsdaten von Sensoren in die digitale Repräsentation einbezogen werden. Während der Qualitätsprüfung (14) wird, automatisch -z.B. mittels Kameras- oder durch eine Bedienperson (34), eine Anomalie (16), die in einer Bauteilregion (20) angesiedelt ist, erkannt und entsprechende Informationen (18) gespeichert. Die Informationen (18) umfassen Attribute, beispielsweise den Ort und den Zeitpunkt der Anomalie (16), Maschinencodes und Produktregionen (20). Aus den semantischen Verknüpfungen der digitalen Repräsentation (8) und der gespeicherten Informationen (8) werden mittels eines Algorithmus semantische Muster errechnet. Diese semantischen Muster dienen dazu, die Ursache der Anomalie (16) zu erkennen.

## Beschreibung

Während der Lebenszyklusentwicklung von Produkten, also zu fertigenden Bauteilen oder mehrere zusammengesetzte Bauteile wird ein langwieriger iterativer Prozess zwischen Planung (z.B. CAD/CAM) und Fertigung/Qualitätskontrolle als Standardprozess für die Erstellung der gefertigten Teile herangezogen. In der Regel werden bei diesem Prozess mehrere Akteure (z. B. Maschinen, Auswertesoftware, Bediener und Produktentwickler) basierend auf ihrer Erfahrung und ihrem Wissen mehrere Parameter und Designentscheidungen treffen, um die Teileanforderungen zu erfüllen. Bisher fehlt ein ganzheitlicher Ansatz, der die Informationen aller Akteure integrieren und kombinieren kann. Aus diesem Grund ist eine nahtlose Datenübertragung zwischen den verschiedenen Lebenszyklusphasen derzeit nicht möglich oder führt zu einer hohen Komplexität und Synchronisationsfehlern. Oft müssen Daten für dasselbe Werkstück entlang seines Lebenszyklus mehrmals gesammelt werden. Darüber hinaus kann das Wissen über Einzelpersonen nicht skaliert werden und geht verloren, wenn der Experte die Position wechselt. Die hohe Komplexität, die derzeit fehlende Skalierbarkeit und der Wissensverlust führen zu hohen Kosten in einem Produktlebenszyklus.

Zum Beispiel können Anomalien bei der Produkt- bzw. Bauteilherstellung, die sich zu Fehlern fortpflanzen können, durch eine Bedienperson oder durch eine Auswertesoftware erkannt werden. Alle beteiligten Akteure können dabei unterschiedlich reagieren, was zu unterschiedlichen Auswertungen über den Herstellungsprozess führt.

Die Aufgabe der Erfindung besteht darin, ein Verfahren zur Erkennung einer Anomalie eines Produktes bereitzustellen, das gegenüber dem Stand der Technik besser geeignet ist, Qualitätsschwankungen eines Produktes bei der Produktion und auch bei der Wartung während eines Lebensdauerzyklus unabhängig von beteiligten Akteuren zu reduzieren.

Die Lösung der Aufgabe besteht in einem Verfahren nach Anspruch 1 sowie in einem Computerprogrammprodukt nach Anspruch 15.

Das erfindungsgemäße Verfahren zur Erkennung von Anomalieursachen eines physischen Produkts während dessen Design, Herstellung und/oder dessen Lebensdauer, umfassend folgende Schritte:
- Erstellen einer semantisch verknüpften digitale Repräsentation 8 des physischen Produkts 2 umfassend dessen Designmerkmale 10 und Herstellungsmerkmale 12
- Übertragen einer Information 18 über Anomalien 16 aus einer Qualitätsprüfung 14 an die digitale Repräsentation 8 und speichern dieser Information 18
- Auffinden von semantischen Mustern zur Erkennung von Anomalieursachen unter Verwendung der Information 18, sowie der Designmerkmale und/oder der Herstellungsmerkmale.

Dabei seien die Begriffe, die zur Beschreibung der Erfindung dienen, wie folgt definiert:
Digitale Repräsentation kann auch als ein digitaler Zwilling eines Konstruktions- und/oder Fertigungsprozesses des Produktes angesehen werden. Die digitale Repräsentation kann dabei Konstruktionsvorgänge umfassen, die beispielsweise durch ein CAD System erfolgen. Sie kann aber auch Fertigungssimulationen, die durch ein CAM Verfahren erfolgen sowie die physische Fertigung an sich umfassen. Bei der physischen Fertigung werden dabei wiederum Prozessdaten wie Prozessüberwachungsdaten von Sensoren und ihre Auswertungen oder das Einspannen eines Bauteilträgers oder die Positionierung und Reihenfolge einzelner Teilbauteile beim Zusammenbau eines Produktes mit in die digitale Repräsentation mit einbezogen. Die digitale Repräsentation kann beispielsweise in Form eines Knowledge Graphs ausgestaltet sein, dieser dient dazu, Informationen zum Bauteil in semantische Relation zueinander zu setzen. Ein digitaler Zwilling im Allgemeinen wiederum ist eine digitale Repräsentation eines materiellen oder immateriellen Objekts oder Prozesses aus der realen Welt in der digitalen Welt. Digitale Zwillinge ermöglichen einen übergreifenden Datenaustausch. Sie sind dabei mehr als reine Daten und bestehen aus Modellen des repräsentierten Objekts oder Prozesses und können daneben Simulationen, Algorithmen und Services enthalten, die Eigenschaften oder Verhalten des repräsentierten Objekts oder Prozesses beschreiben, beeinflussen, oder Dienste darüber anbieten.

Semantische Relation: Hierunter sind u.a. örtliche Beziehungen, räumliche Beziehungen beispielsweise zwischen einem Teil des Produktes während der Fertigung oder einem Roboterarm, der zur Fertigung dient, zu verstehen. Ferner gehören Kausalitäten zu semantischen Relationen, wie beispielsweise die jeweilige Koordinatenbestimmung des Bauteils bezüglich eines Koordinatensystems zum jeweiligen Prozesszeitpunkt oder die während eines bestimmten Prozesszeitpunktes eingebrachte Energiemenge. Eine Mehrzahl an semantischen Relationen ergeben semantische Verknüpfung, die wiederum ein semantisches Muster umfassen kann, wenn sich bestimmte semantische Verknüpfungen wiederholen.

Die Qualitätsprüfung kann während der Herstellung oder auch nach der Herstellung des Produktes während dessen Lebensdauer erfolgen (IEC 62890)

Anomalien sind Erscheinungen am Produkt die von der beabsichtigten und/oder simulierten Qualität abweichen. Anomalien können zum Fehler am Bauteil erwachsen. Sie können oft durch Menschen besonders gut erkannt werden. Erkannter Fehler werden in Information für die semantische Repräsentation umgewandelt.

Designmerkmale und Herstellungsmerkmale: Designmerkmale sind z. B. Konturen und Materialbeschaffenheit des Produktes, diese beeinflussen die funktionalen Eigenschaften des Produktes bzw. Bauteils einerseits und sie wirken sich andererseits auf das Herstellungsverfahren aus. Die Designmerkmale werden üblicherweise mittels eines digitalen Design Verfahrens wie beispielsweise CAD erstellt und die daraus resultierenden Daten können der digitalen Repräsentation als Information zur Verfügung gestellt werden. Die Designmerkmale wirken sich andererseits auf die Herstellungsmerkmale aus.

Herstellungsmerkmale werden beispielsweise mittels eines digitalen Prozessplanungsverfahrens wie CAM erstellt. Sie werden dabei auch aus den digitalen Designmerkmalen abgeleitet und können wiederum als Informationen der digitalen Repräsentation zur Verfügung gestellt werden. Herstellungsmerkmale sind insbesondere Prozessdaten des Fertigungsprozesses. Prozessdaten sind alle Daten, die während des Prozesses anfallen. Dazu gehören die Sensorsignale und zumindest teilweise der Prozessparametersatz. Der Prozessparametersatz umfasst alle während des Prozesses angewandten technischen Größen wie zum Beispiel Position und Geschwindigkeit eines Roboterarms zu einer bestimmten Zeit, insbesondere allerdings Maschineneinstellungen wie beispielsweise Energieeintrag (beispielsweise in Form von Strom und Spannung) und am Beispiel eines additiven Herstellungsverfahrens beispielsweise der Abstand eines Schweißbrenners zum Bauteil, ein Gasfluss oder eine Lichtbogenlängenkorrektur.

Das beschriebene Verfahren geht damit parallel zu einem Produktdesign und einem Fertigungsverfahren (Herstellungsverfahren) einher. Informationen, aus dem Produktdesignverfahren, dem Herstellungsverfahren und der Qualitätsprüfung werden durch das erfindungsgemäße Verfahren in der digitalen Repräsentation aufgearbeitet und es werden semantische Muster aufgespürt, die zu Anomalien und im Weiteren zu Defekten führen können. Durch diese semantischen Muster können Rückschlüsse auf einen Optimierungsbedarf in den einzelnen untersuchten Abschnitten des Produkt Design- und Fertigungsprozess und somit auch auf den gesamten Produkt-Lebensdauer-Zyklus gezogen werden und Verbesserungsvorschläge angezeigt oder automatisiert in Form von Optimierungsmaßnahmen (Closed Loop Control) durchgeführt werden. Insbesondere können durch das beschriebene Verfahren äußere Störeinflüsse, die beispielsweise durch spezifische Eigenheiten der Prozessmittel (wie durch eine bestimmte Robotervorrichtung) aber insbesondere auch durch menschliche Einflüsse (beispielsweise des Bedienpersonals oder eines Konstrukteurs beim Bedienen eines CAD Programmes) eliminiert werden.

Weitere vorteilhafte Ausgestaltungsformen des beschriebenen Verfahrens ergeben sich aus den Unteransprüchen. Vorab seien die in den Unteransprüchen verwendeten Begriff wie folgt definiert:
Innerhalb der digitalen Repräsentation ist ein Knowledge Graph eine Wissensdatenbank, die ein graphstrukturiertes Datenmodell oder eine Topologie verwendet, um Daten wie die Informationen über Anomalitäten zu integrieren. Knowledge Graphs sind dazu geeignet, um miteinander verknüpfte Informationen - wie die Attribute des Produkts, beispielsweise Ort, Zeitpunkt, Bauteilregion, Prozessparameter, Kausalitäten - mit einer semantischen Relation zu speichern.

Eine HMI Schnittstelle ist eine Mensch-Maschine Schnittstelle, diese kann beispielsweise ein herkömmliches Eingabegerät für ein Computer wie eine Tastatur oder eine Maus sein, sie kann aber auch in Form eines VR Trackers oder eines sensitiven Stiftes (Trace pen) ausgestaltet sein.

Maschinencode: Ein Maschinen Code ist eine nach den Regeln einer höheren Programmiersprache erstellte Folge von Anweisungen, die vom Prozessor eines Gerätes, beispielsweise einer Steuerung mit elektronischer Datenverarbeitung direkt (ohne weitere Übersetzung) ausgeführt werden können. Als Beispiel für einen Maschinen Code für Industriesteuerungen wie beispielsweise Sinumerik sei der G-Code (DIN 66025) genannt. Ein anderes Beispiel wäre spezielle Roboter-Programmiersprache wie KRL (Kuka Roboter Language) oder RAPID.

Unter einer Produktregion oder wenn das Produkt ein Bauteil ist, einer Bauteilregion die auch als Region of Interest (ROI) bezeichnet werden kann. Dabei handelt es sich eben nicht nur um einen singulären Punkt, sondern um einen Volumenbereich, der bezüglich der Prozessparameter mit einem Punkt, beispielsweise einer Anomalie in kausalen Zusammenhang steht. Bei einem additiv gefertigten Bauteil könnten es sich dabei beispielsweise um einen an die detektierte Anomalie angrenzenden Punkt in einer darauffolgenden Auftragsschichten handeln, wobei diese Schicht jedoch zeitlich und gegebenenfalls auch örtlich versetzt, aufgetragen wird. Bei dieser Auftragsschicht können bereits andere Prozessparameter vorliegen. Dennoch gehören die Anomalie und der beschrieben Punkt zu einer ROI.

Edge Gerät: Ein Edge-Gerät ist ein Gerät, das einen Knotenpunkt zwischen zwei Netzwerken, beispielsweise zwischen dem beschriebenen Maschinennetzwerk und dem Sensornetzwerk oder zwischen dem Sensornetzwerk und dem Internet darstellt. Dabei kann das Edge Gerät in Form einer Steuerung mit einer Verbindung in ein weiteres Netz ausgestaltet sein.

Cloud Rechner: Bei einer Cloud handelt es sich grundsätzlich um eine vom Ort des beanspruchten Verfahrens örtlich getrennten Rechen- und/oder Speichereinheit, mit der die digitale Repräsentation beispielsweise über eine Edge Gerät datenübertragend verbunden ist. Die Cloud kann dabei einen Cloud Rechner umfassen, der eine höhere Rechenleistung aufweist als die vor Ort vorhandenen Rechner wie beispielsweise das Edge Geräte oder Steuerungen. Demnach können am Cloud Rechner komplexe Berechnungen schneller und effizienter und auch kostengünstiger vorgenommen werden. Somit kann die digitale Repräsentation ganz oder teilweise in einer Cloud allokiert sein. Die dort erzielten Ergebnisse können an lokale Recheneinheit über Datenverbindungen zurück gespiegelt werden.

In einer vorteilhaften Ausgestaltungsform der Erfindung werden die Informationen zu Anomalien in Form von Attributen des Produkts übertragen, wobei die Attribute den Ort und den Zeitpunkt der Anomalie enthalten. Ferner ist es zweckmäßig, dass die Attribute Maschinencodes und Produktregionen enthalten. Es hat sich in der Praxis herausgestellt, dass insbesondere die Attribute, Zeit, Ort, Produktregion und Maschinencode besonders gut geeignet sind, als Informationen in die Digitale Repräsentation eingebracht zu werden und mittels dieser verarbeitet zu werden. Auf Basis dieser Informationen lassen sich besonders gut semantische Muster von auftretenden Anomalien ableiten.

Hierfür ist ein räumliches Koordinatensystem besonders vorteilhaft, in dem das Produkt zu bestimmten Zeitpunkten mit Ortskoordinaten versehen wird.

In einer zweckmäßigen Ausgestaltungsform umfasst die digitale Repräsentation einen Knowledge Graph, auf dessen Basis die semantischen Muster abgeleitet werden. Wobei mittels des Knowledge Graphs zumindest die Attribute Ort und Zeit des Produkts in eine semantische Relation gesetzt werden.

Ferner ist es zweckmäßig, dass eine Schnittstelle vorgesehen ist, über die Informationen über Anomalien in die digitale Repräsentation übertragen wird. Die Schnittstellen ist wiederum in vorteilhafter Weise in Form von HMI Schnittstellen ausgestaltet. Diese Kann eine Tastatur oder ein Eingabegerät sein, durch die beispielsweise das Produktdesign erfolgt oder durch die Prozessparameter angepasst werden. Fern kann die HMI Schnittstelle auch in Form einer koordinatenabhängigen Markiereinheit ausgestaltet ist. Dies ist insbesondere bei der Qualitätsprüfung zweckmäßig. Die Ausgestaltung der Schnittstelle kann beispielsweise in Form eines Virtual Reality Trackers ausgestaltet sein.

Eine weitere vorteilhafte Ausgestaltung der Erfindung besteht darin, dass Berechnungen zur Darstellung der digitalen Repräsentation, insbesondere des Knowledge Graphs mittels eines Cloud-Rechners durchgeführt werden. Der Vorteil liegt dabei darin, dass hierdurch auf Leistungsstarke Rechner zurückgegriffen werden kann, die nicht notwendigerweise am Ort der Herstellung der Produktion angeordnet sein müssen. Dies spart Investitionskosten, da die Rechenleistung vor Ort auf ein optimales Maß reduziert werden kann.

Vor Ort kann beispielsweise ein Edge Gerät vorgesehen sein, dass die Verbindung zum Cloud Rechner herstellt und mittels dessen die Informationen analysiert werden und übermittelt werden. Das Edge Gerät kann auch in eine Prozesssteuerung integriert sein.

Das beschrieben Verfahren eignet sich zur Erkennung von Anomalien bei sehr unterschiedlichen Fertigungsverfahren. Das physische Produkt kann dabei aus einem Zusammensetzten verschiedener Einzelprodukte bestehen (Montageverfahren), es kann aber auch der Fertigungsprozess eines einzelnen Bauteils durch das beschriebene Verfahren betrachtet werden. Besonders geeignet ist es dabei für die Überwachung eines additiven Fertigungsverfahren, wie beispielsweise ein Wire Arc Additive Manufacturing Verfahren oder ein Laserauftragsschweißverfahren.

Ein weiterer Bestandteil der Erfindung ist ein Computerprogrammprodukt, das dazu ausgebildet ist, bei der Ausführung auf einem Computer die Verfahrensschritte eines der Ansprüche 1 bis 14 durchzuführen.

Weitere vorteilhafte Ausgestaltungsformen und weitere Merkmale der Erfindung werden anhand der Figuren näher beschrieben Dabei werden Merkmale mit derselben Bezeichnung aber in unterschiedlichen Ausgestaltungsformen in den Figuren mit demselben Bezugszeichen versehen.

Dabei zeigen:
Figur 1, einen schematischen Ablauf eines Verfahrens zur Erkennung von Anomalieursachen mit Piktogrammen einzelner betrachteter Produktlebenszyklusabschnitten,
Figur 2, eine schematische Darstellung einer digitalen Repräsentation in Form eines Knowledge Graphs.

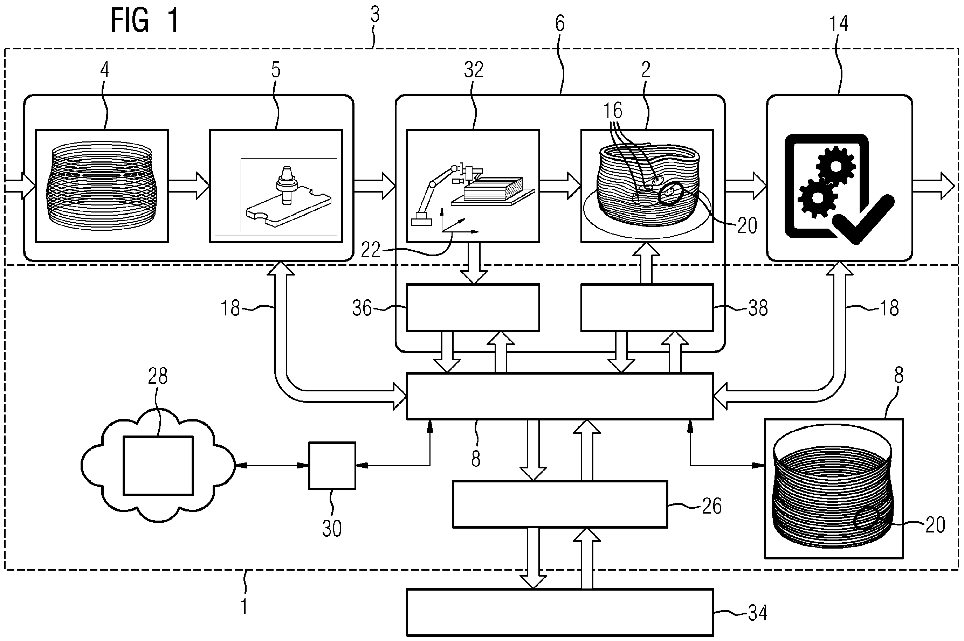

Die Grafik in Figur 1 zeigt einerseits einen schematischen Ablauf eines Verfahrens zur Erkennung von Anomalieursachen 1 zum anderen einen Produktzyklus 3 eines physischen Produktes 2. Dabei sind die gewählten Einzelschritte des Produktzyklus 3 rein exemplarisch zu sehen und sie können durch andere Anwendungen ersetzt werden. Die Grafik zeigt den Produktzyklus 3 des physischen Produktes 2, der von dem ProduktDesignverfahren 4 bis zur Qualitätskontrolle 14 reicht. Dieser Zyklus 3 kann auch noch erweitert werden, beispielsweise können noch Qualitätsprüfung des Produktes 2 während dessen gesamten Lebensdauer mit einbezogen werden.

Am Anfang des Produktzyklus steht ein Designverfahren 4, beispielsweise in Form eines CAD Verfahrens. Hierbei wird in der Regel durch eine Person das physische Produkt 2 entworfen. Dabei bringt die Person in Form des Designers ihrer eigenen persönlichen Vorstellungen davon mit ein, wie das Produkt technisch am besten zu designen ist. Die konkrete Umsetzung des Designs kann jedoch bei der Anwendung des Produkts 2 oder bei der Herstellung zu technischen Nachteilen führen. Der weitere Schritt, der nun folgt, ist in der Regel die Umsetzung der CAD Daten in ein computerunterstütztes Fertigungsprogramm (CAM) 5. dieses Fertigungsprogramm 5 setzt die Designvorgaben in Prozessparameter für die Fertigung des physischen Produktes 2 um.

Das Produkt wird demnach in CAD (z. B. Siemens NX) konstruiert und die Prozessplanung erfolgt in CAM (ebenfalls z. B. Siemens NX). Für den Fertigungsprozess kann die digitale Prozessplanung auf Maschinencode (G-Code) geparst werden, der von einer Siemens Sinumerik Steuerung / CNC-Steuerung, die den Fertigungsprozess steuert, gelesen werden kann.

Als nächstes folgt eine Fertigung 6 des physischen Produktes an sich. In dem vorliegenden Beispiel ist hierbei eine robotergesteuerte Fertigung eines additiv hergestellten Bauteils dargestellt, das das Produkt 2 bildet. Diese Darstellung ist hierbei rein exemplarisch gewählt. Es kann sich hierbei beispielsweise auch um einen Gießprozess oder Extrusionsprozess eines Bauteiles handeln, das damit als physisches Produkt 2 bezeichnet wird. Grundsätzlich ist es auch möglich, verschiedene schon bestehende Bauteile zu einem zusammengesetzten Produkt 2 zu fertigen. Das im weiteren beschriebenen Verfahren kann auf beliebige Herstellungsverfahren angewandt werden.

Im nächsten Schritt ist in Figur 1 das gefertigte physische Produkt 2 in Form eines additiv hergestellten Bauteils dargestellt. Hierbei ist eine Anomalie 16 zu erkennen, die in einer Bauteilregion 20 angesiedelt ist. Die Anomalie 16 ist zunächst eine reine Abweichung von einem optimalen Zustand, der im Produktionsprozess mittels des CAM vorgesehen sind. Eine Anomalie 16 muss noch keinen Fehler an sich darstellen, sie kann sich jedoch bei der Weiterführung des Prozesses ohne Begutachtung und/oder dem Einleiten von Gegenmaßnahmen zu einem Fehler fortsetzen. Das Einleiten von Gegenmaßnahmen während des Prozesses wird auch als Closed Loop Control 38 bezeichnet.

Häufig werden in den beschriebenen Prozessen im Rahmen der Qualitätsprüfung 14 und/oder der Prozesskontrolle 36 Bedienpersonen 34 damit beauftragt, Anomalien 16 an entstehenden physischen Produkten 2 zu entdecken und diese zu markieren. Grundsätzlich kann dies auch durch eine bestimmte automatisierte Qualitätssicherung, beispielsweise mithilfe von speziellen, hier nicht dargestellten Kameras und einer Auswertungssoftware erfolgen. Bedienpersonen 34 können jedoch in komplexen Prozessen immer noch besser Anomalien erkennen, als dies technisch basierte Vorrichtungen vermögen. Bei unterschiedlichen Bedienpersonen 34 können jedoch die Erkennungsschwellen von Anomalien 16 oder die Art der Eingabe über eine Schnittstelle 26 unterschiedlich sein. Diese Unzuverlässigkeit und eingeschränkter Reproduzierbarkeit von Verhalten von Bedienpersonen 34 beeinträchtigt jedoch den automatisierten Prozessablauf.

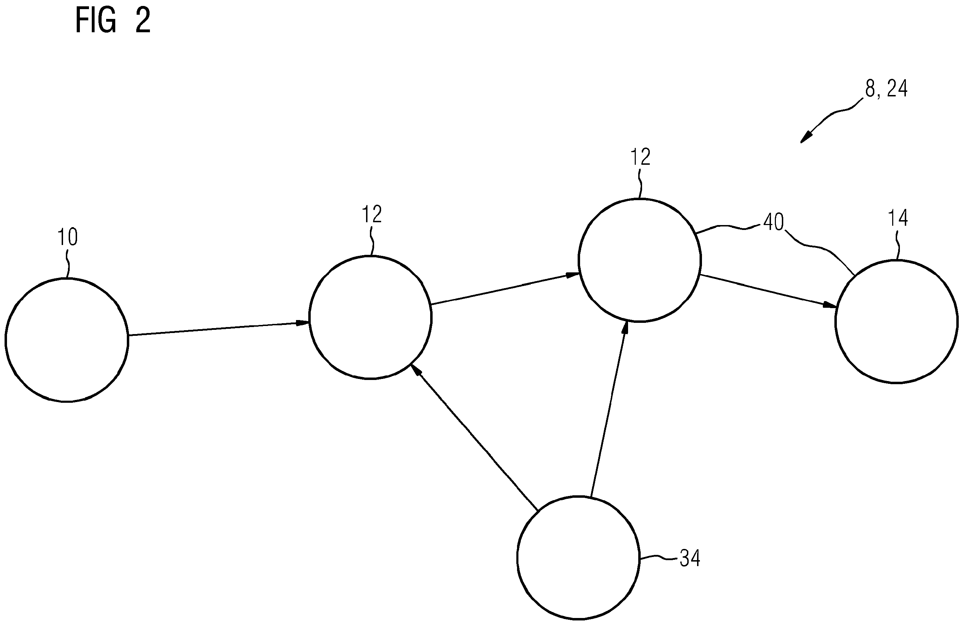

Daher ist ein Verfahren 1 zur Erkennung von Anomalieursachen vorgesehen, dass verschiedene Informationen 18 aus dem Prozesszyklus 3 auswerten kann. Hierzu wird eine digitale Repräsentation 8 des Produktes 2 einschließlich seines Designs und Herstellungsmerkmale erstellt. Eine derartige digitale Repräsentation 8 kann auch als digitaler Zwilling bezeichnet werden. Die digitale Repräsentation umfasst dabei einen sogenannten Knowledge Graph 24, der semantischen Verknüpfungen der Informationen 18, die in die digitale Repräsentation 8 eingespeist werden, umfasst. In die digitale Repräsentation 8 werden auch aufgezeichnete Prozessparameter einschließlich Sensordaten als Informationen 18 mit eingebracht und kontinuierlich synchronisiert. Aus diesen semantischen Verknüpfungen, die exemplarisch in Figur 2 dargestellt sind, können mittels eines Algorithmus semantische Muster errechnet werden. Diese semantischen Muster dienen wieder dazu, Anomalieursachen zu erkennen.

Anomalieursachen können hierbei beispielsweise Fehler im Design sein, andererseits können auch Fehler bei der Prozessführung, die wiederum durch das CAM Verfahren verursacht sein können, die Ursache für Anomalien 16 sein. Auch die Markierung von Anomalien 16 durch eine Bedienpersonen 34, die dem Prozess visuell überwacht und beispielsweise mit einer koordinatenabhängigen Markiereinheit (die als Schnittstelle 26 zu sehen ist, beispielsweise ein Laser Pointer oder ein sensitiver Stift) die Anomalie 16 markiert und dadurch Informationen 18 über die Anomalie 16 in die digitale Repräsentation 8 einbringt, können bei unterschiedlicher Handhabung wiederum Anomalieursachen darstellen. Das liegt daran, dass unterschiedliche Bedienpersonen 34 möglicherweise die Markiereinheit unterschiedlich handhaben und bedienen.

Somit wird eine Vielzahl an unterschiedlichen Informationen 18 über Anomalien 16 in der digitalen Repräsentation 8 eingebracht und gespeichert. Diese Informationen 18 können einerseits typisches, auf ein Individuum bezogenes, menschliches Verhalten und/oder Abweichungen von einem technischen Normverhalten beinhalten. Beide unterschiedlichen Ursachen können den optimalen Produktzyklus stören und zu Anomalien 16 und im Weiteren zu Fehlern am Produkt 2 führen.

Mittels des Knowledge Graph 24 der digitalen Repräsentation 8 werden mittels komplexer Algorithmen Auswertungen durchgeführt, um mögliche semantische Muster, die zu Anomalien führen können, ermittelt. Hierfür sind im Knowledge Graph 24 auch Design und Fertigungsdaten aus dem CAD und/oder CAM System als Informationen gespeichert und stehend für die Auswertung semantischer Muster zur Verfügung. Solche semantischen Muster können beispielsweise Besonderheiten im Design, die mit speziellen Prozessparametern korrespondieren und dabei zu Anomalien führen, aufdecken. Ferner können bestimmte Eigenheiten von Bedienpersonen 34 beispielsweise bei der Qualitätsprüfung 14 ebenfalls zu veränderten Informationen 18 über Anomalien führen, die wiederum die Prozessführung rückkoppelnd beeinflussen. Die Speicherung von Informationen über bestimmende Bedienpersonen 34 und ihrer Verhaltensmuster bezüglich der Qualitätsprüfung können im Knowledge Graph 24 gespeichert sein und bei der Auswertung der Informationen zu einem semantischen Muster führen, dessen Resultat eine veränderte Prozessführung zur Folge haben kann.

Das Auffinden von semantischen Mustern innerhalb eines Knowledge Graph 24 mittels der beschriebenen Algorithmen kann eine sehr hohe Rechnerleistung erfordern. Derartig hohe Rechnerleistung sind in Werkshallen im direkten Umfeld von Produktionsanlagen häufig nicht verfügbar oder sie sind aus Kostengründen dort nur unwirtschaftlich anzubringen. Aus diesem Grund ist es zweckmäßig, einen Cloud Rechner 28 für die Auswertung des Knowledge Graph 24 und zur Auffindung von semantischen Mustern heranzuziehen. Dieser Cloud Rechner 28 kann beispielsweise durch ein Edge Gerät 30, mit dem Fertigungsprozess bzw. mit dem Produktzyklus 3 verbunden sein. Dabei kann das Edge Gerät 30 beispielsweise Teil einer Prozesssteuerung wie beispielsweise eine Sinumerik Edge sein.

Eine vorteilhafte Besonderheit des beschriebenen Verfahrens ist die Darstellung des Produktes 2 mittels vier Hauptattribute, nämlich die Zeit, den Ort, Bauteilregion 20 (Region of Interest (ROI)) und einen Maschinencode (z.B. G-Code) und durch die Integration von Kontextinformationen, die von Standorten gegeben werden, ist eine Verbindung zwischen den Attributen möglich. Hierbei kommt bevorzugt ein Koordinatensystem 22 zum Tragen, über das die Position des Produktes 2 und die Position von Fertigungsmitteln wie einem Roboterarm einheitlich bestimmt werden kann.

Die Vernetzung zwischen den verschiedenen Domänen (Zeit, Ort, Maschinencode, u. a.) erfolgt durch die Erstellung der digitalen Repräsentation 8 also eines Digitalen Zwillings des sich in Produktion befindlichen Produkts 2 unter Zuhilfenahme des beschriebenen Knowledge Graph 24. Durch diese Methodik wird die Semantik für jeden Punkt des Teils mit den vier oben genannten Attributen korreliert, wodurch eine flexible Beziehung zwischen Wissen aus den verschiedenen Domänen aufgebaut wird. Der Knowledge Graph 24 wird unter Verwendung des Eingabe-/Prozess-/Ausgabeentitätsmodells für Knoten 40 erstellt. Daher nimmt beispielsweise bei einem additiven Fertigungsverfahren jeder Schweißpunkt als Eingabe die Standorte des Nachbarschweißpunktes, die als ROI (eine Ansammlung von Schweißpunkten) und Prozessparameter (z. B. Gcode, Zeit, Standort, maximale Temperatur usw.) bezeichnet werden, auf. An diesem Punkt kann die Bedienperson 34 mit dem Knowledge Graph 24 interagieren. Hierfür werden bevorzugt Domain-Expertise Schnittstellen verwendet. Die Schnittstellen (HMI) können vielfältig sein, hauptsächlich abhängig von der Bedienperson 34 und dem überwachten Prozess. Diese Schnittstellen 26 kommunizieren mit der digitalen Repräsentation, weisen der Produktregion 20 (ROI) Attribute zu und verbessern so den Knowledge Graph 24. Eine automatische Korrelation zwischen den verschiedenen Domänen sowie den verschiedenen Phasen im Prozesszyklus 3 mittels des Knowledge Graph 24 ermöglicht die Optimierung jedes Prozessschrittes (CAD/CAM/Prozessparameter/Anwendung).

Durch das beschriebene Verfahren können auch nachträglich Ausfälle des Produktes während seiner Lebensdauer mit bestimmten Prozessparametern und Prozesssituationen einschließlich über Verhaltensmustern von Bedienpersonen 34 in Verbindung gebracht werden. Ferner wird hierdurch eine Kostenreduktion, durch einen reduzierten Arbeitsaufwand bewirkt, da Informationen automatisch integriert werden könne und Korrelationen durch Data Mining im Knowledge Graph automatisch abgeleitet werden können.

### Bezugszeichenliste

- 1: Verfahren zur Erkennung v. Anomalieursachen
- 2: physisches Produkt
- 3: Produktzyklen
- 4: Designverfahren
- 5: computerunterstütztes Fertigungsprogramm
- 6: Herstellungsverfahren
- 8: digitale Repräsentation
- 10: Designmerkmale
- 12: Herstellungsmerkmale
- 14: Qualitätsprüfung
- 16: Anomalien
- 18: Information
- 20: Produktregionen
- 22: Koordinatensystem
- 24: Knowledge Graph
- 26: Schnittstelle
- 28: Cloud Rechner
- 30: Edge Gerät
- 32: additives Fertigungsverfahren
- 34: Bedienperson
- 36: Prozesskontrolle
- 38: Closed Loop Control
- 40: Knoten Knowledge Graph

## Patentansprüche

1. Verfahren zur Erkennung von Anomalieursachen eines physischen Produkts 2 während dessen Design 4, Herstellung 6 und/oder dessen Lebensdauer, umfassend
- Erstellen einer semantisch verknüpften digitale Repräsentation 8 des physischen Produkts 2 umfassend dessen Designmerkmale 10 und Herstellungsmerkmale 12
- Übertragen einer Information 18 über Anomalien 16 aus einer Qualitätsprüfung 14 an die digitale Repräsentation 8 und speichern dieser Information 18
- Auffinden von semantischen Mustern zur Erkennung von Anomalieursachen unter Verwendung der Information 18, sowie der Designmerkmale und/oder der Herstellungsmerkmale.

2. Verfahren nach Anspruch 1, **dadurch gekennzeichnet, dass** die Informationen 18 zu Anomalien 16 in Form von Attributen des Produkts übertragen werden, wobei die Attribute den Ort und den Zeitpunkt der Anomalie 16 enthalten.

3. Verfahren nach Anspruch 2, **dadurch gekennzeichnet, dass** die Attribute Maschinencodes und Produktregionen enthalten

4. Verfahren nach Anspruch 1 bis 3, **dadurch gekennzeichnet, dass** ein räumliches Koordinatensystem 22 vorgesehen ist, in dem das Produkt 2 zu bestimmten Zeitpunkten mit Ortskoordinaten versehen wird.

5. Verfahren nach einem der vorhergehenden Ansprüche,
**dadurch gekennzeichnet, dass** die digitale Repräsentation 8 einen Knowledge Graph 24 umfasst.

6. Verfahrenen nach einem der Ansprüche 2 bis 5, **dadurch gekennzeichnet, dass** mittels des Knowledge Graphs 24 zumindest die Attribute Ort und Zeit des Produkts in eine semantische Relation gesetzt werden.

7. Verfahren nach einem der vorhergehenden Ansprüche,
**dadurch gekennzeichnet, dass** eine Schnittstelle 26 vorgesehen ist, über die Informationen 18 über Anomalien 16 in die digitale Repräsentation 8 übertragen werden.

8. Verfahren nach Anspruch 7, **dadurch gekennzeichnet, dass** die Schnittstellen 26 in Form von HMI Schnittstellen ausgestaltet sind.

9. Verfahren nach Anspruch 7 oder 8, **dadurch gekennzeichnet, dass** die Schnittstelle 26 in Form einer koordinatenabhängigen Markiereinheit ausgestaltet ist.

10. Verfahren nach einem der Ansprüche 7 bis 9, **dadurch gekennzeichnet, dass** Schnittstelle in Form eines Virtual Reality Trackers ausgestaltet ist.

11. Verfahren nach einem der vorhergehenden Ansprüche, **dadurch gekennzeichnet, dass** Berechnungen zur Darstellung der digitalen Repräsentation 8, insbesondere des Knowledge Graphs 24 mittels eines Cloud-Rechners 28 durchgeführt werden.

12. Verfahren nach Anspruch 11, **dadurch gekennzeichnet, dass** die Informationen mittels eines Edge Geräts 30 analysiert werden und mittels des Edge Geräts 30 eine Verbindung zum Cloud Rechner 28 hergestellt wird.

13. Verfahren nach einem der vorhergehenden Ansprüche, **dadurch gekennzeichnet, dass** das physische Produkt 2 mittels eines additiven Fertigungsverfahren 32 hergestellt wird.

14. Verfahren nach Anspruch 13, **dadurch gekennzeichnet, dass** das additive Fertigungsverfahren 32 in Form ein Wire Arc Additive Manufacturing Verfahren oder ein Laserauftragsschweißverfahren verwendet wird.

15. Computerprogrammprodukt, das dazu ausgebildet ist, bei der Ausführung auf einem Computer die Verfahrensschritte eines der Ansprüche 1 bis 14 durchzuführen
